# FASCICULE DE BREVET EUROPEEN

(11) **EP 0 474 550 B1**
(45) Date de publication et mention de la délivrance du brevet: **19.07.1995**
(21) Numéro de dépôt: 91402353.6
(22) Date de dépôt: 03.09.1991
(51) Int. Cl.: H04N 3/15, H04N 5/335, H01L 27/148

(54) **Détecteur d'images à pixels de grandes dimensions**
Bilddetektor mit Grossformat-Pixels
Image detector with large sized pixels

(30) Priorité: 07.09.1990 FR 9011120
(43) Date de publication de la demande: 11.03.1992
(73) Titulaire: THOMSON-CSF SEMICONDUCTEURS SPECIFIQUES, 92800 Puteaux (FR)
(72) Inventeur: Cazaux, Yvon, F-92045 Paris la Défense (FR); Coutures, Jean-Louis, F-92045 Paris la Défense (FR); Dautriche, Pierre, F-92045 Paris la Défense (FR); Boucharlat, Gilles, F-92045 Paris la Défense (FR)
(74) Mandataire: Guérin, Michel

(56) Documents cités:
- EP-A- 0 168 267
- EP-A- 0 207 826
- GB-A- 2 113 949
- US-A- 4 280 141
- US-A- 4 930 006
- PATENT ABSTRACTS OF JAPAN, vol. 9, no. 320 (P-413)[2043], 14 décembre 1985;& JP-A-60 146 165
- PATENT ABSTRACTS OF JAPAN, vol. 9, no. 75 (E-306)[1798], 4 avril 1985;& JP-A-59 210 775
- PATENT ABSTRACTS OF JAPAN, vol. 10, no. 251 (E-432)[2307], 28 août 1986;& JP-A-61 079 379

## Description

L'invention s'applique aux dispositifs capteurs d'images formés de semiconducteurs photosensibles, et plus particulièrement à de tels dispositifs comprenant au moins une surface photosensible dite de "grande dimension".

Les dispositifs capteurs d'image à semiconducteurs comprennent le plus souvent soit une pluralité d'éléments photosensibles disposés en lignes et en colonnes, soit une unique ligne de ces éléments photosensibles qui constituent alors une barrette. Chaque élément photosensible correspond à un point élémentaire d'image, et les dimensions de ce point élémentaire d'image sont liées à celles de la surface photosensible de l'élément capteur. Dans la suite de la description on appelle "pixel" la surface photosensible d'un élément capteur. Il est à noter que dans certains cas, le dispositif capteur d'images peut comporter un unique élément photosensible, c'est-à-dire un seul pixel.

Les pixels ont des dimensions qui varient avec l'application. Par exemple, quand on cherche à obtenir une grande résolution d'image, on utilise des pixels de faibles dimensions (par exemple 10 »m x 10 »m). Dans d'autres cas, on utilise des pixels dits "de grandes dimensions" (par exemple de l'ordre de 100 »m x 100 »m), notamment dans une application aux communications entre satellites.

Les éléments photosensibles semiconducteurs sont couramment des photodiodes ou bien des éléments réalisés suivant la technologie MOS (de l'anglais "Metal Oxyde Semiconductor"). Dans la technologie MOS, on réalise une capacité en déposant, sur un substrat semiconducteur, une couche isolante formée d'un oxyde, elle-même recouverte d'une couche conductrice ; cette couche conductrice constitue une électrode et elle est souvent réalisée en une couche de silicium polycristallin. Suivant cette technologie MOS on réalise couramment, sur un même substrat semiconducteur, une succession de telles capacités pouvant former une succession d'étages d'un registre à décalage du type à transfert de charges ou en abrégé "CCD" (de l'anglais "Charges Coupled Device"). Dans ces registres à transfert de charges, chaque étage peut collecter des charges engendrées par la lumière et stocker ces charges. Ces charges sont ensuite transférées d'un étage à l'autre jusqu'à un registre de lecture lui-même du type CCD. Ainsi chaque capacité de type MOS peut constituer un élément photosensible qui est connu sous le nom de photomos, nom sous lequel il est appelé dans la description.

Dans les capteurs d'images ou imageurs ayant des pixels de grandes dimensions, ces pixels sont constitués par des photodiodes. Ces capteurs d'images sont formés généralement de N lignes comportant M point photosensible chacune (avec N égal ou supérieur à 1 et M égal ou supérieur à 1). Un imageur surfacique de ce type peut être obtenu en juxtaposant plusieurs lignes ou barrettes de photodiodes. On associe à chaque ligne un registre à décalage du type CCD constituant un registre de lecture dont chaque étage correspond à une photodiode ou pixel.

Pour la lecture, on transfère les charges de chaque pixel dans l'étage correspondant du registre de lecture (simultanément pour toutes les lignes), puis on vide le registre vers un circuit de sortie permettant notamment de convertir les charges en tension ; il y a donc dans ce cas autant de sorties qu'il y a de lignes.

Suivant une autre architecture connue, l'imageur se présente sous une forme matricielle. Dans ce cas d'une part, chaque photodiode est reliée à un conducteur en colonne, par l'intermédiaire d'un élément de commutation constitué souvent d'un transistor de type MOS ; d'autre part, chaque colonne est reliée à un étage d'un registre à décalage du type CCD. La lecture est réalisée suivant un adressage ligne par ligne : on commande à l'état "passant'' tous les éléments de commutation d'une même ligne, de telle manière que dans chaque conducteur colonne circule les charges accumulées par une photodiode appartenant à la ligne adressée. Ces charges sont stockées dans l'étage correspondant du registre, puis ce dernier ayant été vidé, on réalise l'adressage de la ligne suivante.

Dans l'application aux pixels de grandes dimensions, les photomos sont écartés du fait qu'ils présentent notamment comme inconvénient, d'exiger un temps relativement grand pour évacuer de façon correcte les charges accumulées ou stockées (le pas des photomos doit être compatible avec le transfert des charges).

Avec les photodiodes, ce défaut est beaucoup moins prononcé, mais les photodiodes ont d'autres inconvénients graves liés à la forte capacité qu'ils présentent. Cette forte capacité des photodiodes entraîne notamment un bruit de lecture très important, ainsi qu'un effet de traînage ou rémanence très pénalisant.

La présente invention propose une architecture nouvelle de capteur d'images, permettant de réaliser au moins un pixel de grandes dimensions, sans rencontrer les inconvénients ci-dessus cités. Ceci est obtenu notamment en utilisant une pluralité de capteurs ou éléments photosensibles de type photomos, c'est-à-dire de type CCD, ayant chacun au maximum une dimension compatible avec un transfert correct des charges dans le temps imparti, pour former une surface photosensible correspondant à un pixel de grandes dimensions, et en réalisant la sommation des informations élémentaires contenues dans chacun de ces photomos.

Selon l'invention, un dispositif capteur d'images comportant un réseau de surfaces photosensibles principales disposées suivant N lignes principales et M colonnes principales avec N égal ou supérieur à 1 et M égal ou supérieur à 1, chaque surface photosensible principale produisant des charges en fonction de son éclairement, est caractérisé en ce que chaque surface photosensible principale comprend un réseau de photomos disposés suivant j lignes intermédiaires et i colonnes intermédiaires avec j égal ou supérieur à 2 et i égal ou supérieur à 1), lesdits photomos d'une même surface photosensible principale étant éclairés simultanément, chaque ligne de surfaces photosensibles principales comportant un registre de lecture ayant au moins mutant d'étages de lecture qu'il y a de colonnes intermédiaires dans une ligne principale, chaque succession de photomos suivant le sens des colonnes intermédiaires constituant un registre à décalage aboutissant à un étage de lecture, chaque étage de lecture ayant la capacité de stocker la totalité des charges accumulées dans la colonne intermédiaire correspondante.

L'invention sera mieux comprise et d'autres avantages qu'elle procure apparaîtront à la lecture de la description qui suit, faite à titre d'exemple non limitatif en référence aux figures annexées, parmi lesquelles :
- la figure 1 est un schéma d'une première version d'un capteur d'images conforme à l'invention,
- la figure 2 montre schématiquement de façon plus détaillée, une surface photosensible montrée à la figure 1,
- la figure 3 montre schématiquement la surface photosensible de la figure 2 fonctionnant avec des étages de sommation,
- la figure 4 est un chronogramme illustrant le fonctionnement du dispositif de l'invention, dans la version correspondant à la figure 3.

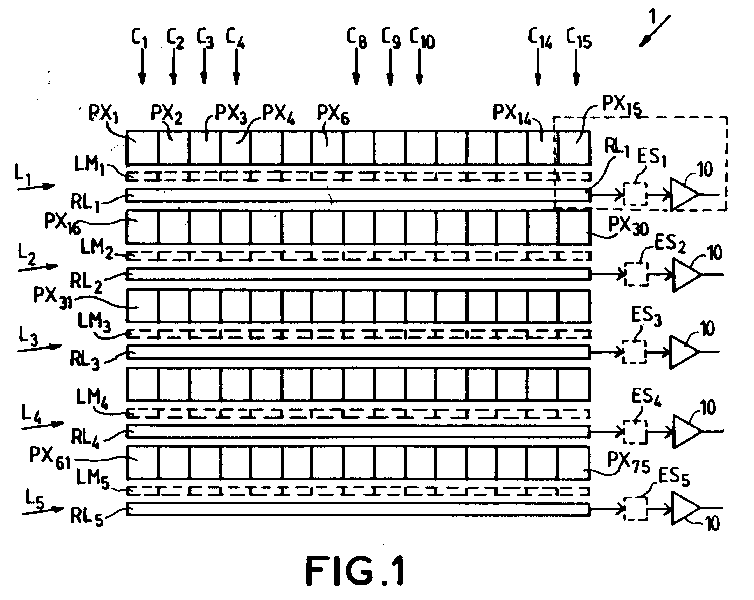

La figure 1 représente de façon schématique un capteur d'image 1 suivant l'invention.

Le capteur d'image 1 comporte une zone image formée par un réseau de N fois M surfaces photosensibles principales, constituant chacune un pixel PX1 à PX75 de grande dimension appelé dans la suite de la description gros pixel (on considère qu'un pixel est de grande dimension quand ces dimensions deviennent incompatibles avec un fonctionnement correct dans un capteur d'image conventionnel). Les gros pixels sont disposés suivant N lignes et M colonnes. Dans l'exemple non limitatif montré à la figure 1, N = 5 et M = 15, et en conséquence, cinq lignes L1 à L5 de gros pixels PX1 à PX75 et quinze colonnes C1 à C15 sont représentées ; mais dans le cadre de l'invention, le nombre N de lignes étant égal ou supérieur à 1, le capteur d'image 1 peut comporter un nombre plus grand de gros pixel ou un unique gros pixel PX1.

Chaque ligne L1 à L5 comporte un registre de lecture RL1 à RL5 destiné à évacuer vers un circuit de sortie 10, les charges produites au niveau des gros pixels PX1 à PX75 quand ils sont exposés à un rayonnement, de lumière par exemple.

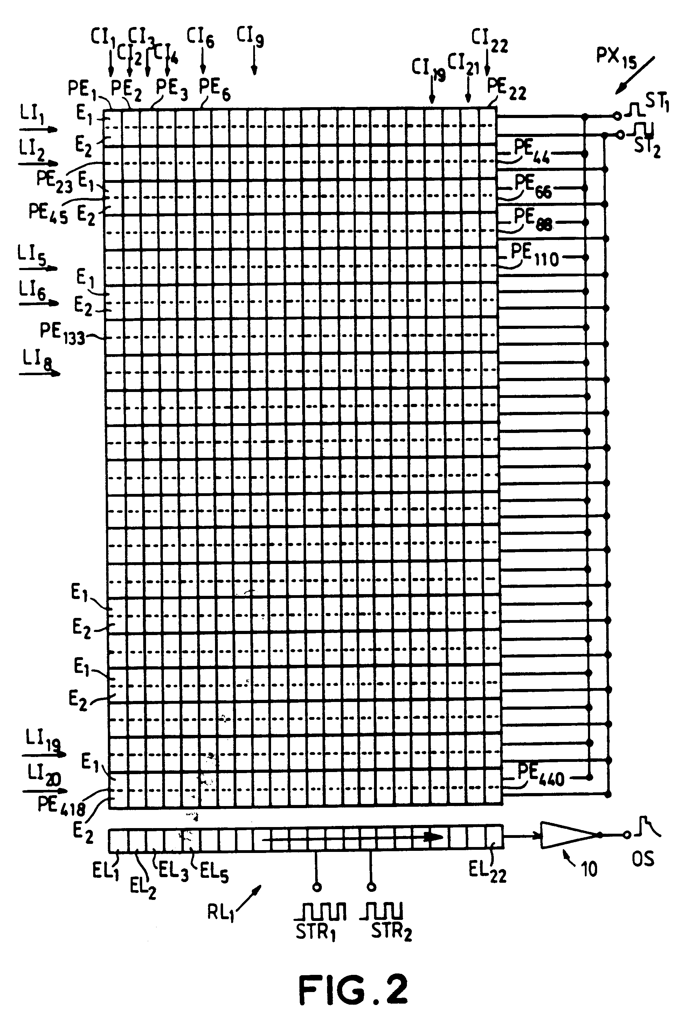

Suivant une caractéristique de l'invention, chaque surface photosensible ou gros pixel PX1 à PX75 est constitué par un réseau matriciel de pixels élémentaires ainsi que montré à la figure 2.

La figure 2 est une vue agrandie d'un gros pixel montré à la figure 1 dans un encadré, le quinzième pixel PX15 par exemple.

La figure 2 illustre la réalisation d'un gros pixel PX15 à l'aide d'un réseau de j fois i pixels élémentaires, chacun formé par un photomos. Les photomos ou pixels élémentaires sont disposés suivant j lignes intermédiaires et i colonnes intermédiaires. Le terme "intermédiaire" attribué à ces lignes et colonnes intermédiaires, permet de mieux les différencier des lignes et colonnes formées par les gros pixels et qui sont appelées "lignes principales L1 à L5 et colonnes principales C1 à C15 dans la suite de la description. Le nombre j est égal ou supérieur à 2 et le nombre i est égal ou supérieur à 1. En fait le nombre j définit le nombre de pixels élémentaires dans une colonne intermédiaire, et au minimum ce nombre doit être tel que le transfert des charges soit correctement accompli en fonction du temps imparti ; cependant, avec un unique pixel élémentaire par colonne intermédiaire l'invention perd son intérêt et le nombre j minimum est donc 2.

Dans l'exemple non limitatif décrit, j = 20 et i = 22, par suite 20 lignes intermédiaires LI1 à LI20 et 22 colonnes intermédiaires CI1 à CI22 sont représentées, qui forment 440 pixels élémentaires PE1 à PE440. Pour une question de commodité de représentation, la dimension des pixels élémentaires PE1 à PE440 est montée plus grande dans le sens des colonnes intermédiaires que dans le sens des lignes intermédiaires, mais bien entendu ces pixels élémentaires peuvent avoir une géométrie différente.

Les pixels élémentaires PE1 à PE440 sont constitués par des photomos en eux-mêmes classiques, de manière que dans le sens des colonnes intermédiaires CI1 à CI22, ils puissent constituer de manière conventionnelle une succession d'étage de transfert. Ils peuvent ainsi former un registre de transfert, transférant les charges dans le sens de la première ligne intermédiaire LI1 vers un registre de lecture RL1 situé à l'autre extrémité des colonnes intermédiaires après la vingtième ligne intermédiaire LI20.

Ce transfert peut s'effectuer indifféremment en mode biphasé, trois ou quatre phases. Dans l'exemple non limitatif décrit, il est effectué en biphasé à l'aide de deux signaux de transfert ST1, ST2 ayant des phases différentes. A cette fin, chaque pixel élémentaire PE1 à PE440 comporte, de façon en elle-même classique, deux couples d'électrodes E1, E2 qui se succèdent dans le sens des colonnes intermédiaires CI1 à CI22 et auxquelles sont appliqués les signaux de transfert ST1, ST2.

Le registre de lecture est un registre à décalage CCD. Il comporte au moins autant d'étages de lecture EL1 à EL22 qu'il y a de colonnes intermédiaires CI1 à CI22. En fait, le registre de lecture RL1 peut être commun à plusieurs gros pixels, situés sur une même ligne principale L1 à L5. Aussi, le nombre des étages de lecture doit au moins être égal au nombre total des colonnes intermédiaires que comporte une ligne principale L1 à L5, de manière que dans tous les cas, à chaque colonne intermédiaire corresponde un étage de lecture.

Suivant une autre caractéristique de l'invention, chaque étage de lecture EL1 à EL22 est conçu (dans ses dimensions par exemple), pour pouvoir stocker la somme des quantités de charges accumulées dans les différents pixels élémentaires PE1 à PE440 qui forment la colonne intermédiaire CI1 à CI22 à laquelle l'étage de lecture correspond.

Dans ces conditions, le fonctionnement du dispositif capteur 1 d'image est le suivant :
- après une phase d'exposition à la lumière dans laquelle tout ou partie de la surface photosensible c'est-à-dire du gros pixel PX15 est exposé, on applique les signaux de transfert ST1, ST2 à toutes les électrodes E1, E2 de tous les pixels élémentaires PE1 à PE440. Ces derniers fonctionnent alors comme des registres et, dans le sens des colonnes intermédiaires, transfèrent les charges éventuellement accumulées par chacun d'eux, pour les charger dans l'étage de lecture EL1 à EL22 correspondant ; le registre de lecture RL1 étant bien entendu arrêté. Chaque cycle des signaux de transfert ST1, ST2 décale d'une case (c'est-à-dire d'un pixel élémentaire) vers le registre de lecture, les charges accumulées dans chacun des pixels élémentaires. Dans l'exemple illustré à la figure 2 où chaque colonne intermédiaire comprend 20 pixels élémentaires, il faut 20 cycles des signaux de transfert pour que les charges engendrées dans les pixels élémentaires PE1 à PE22 de la première ligne intermédiaire LI1 soit transférées dans l'étage de lecture correspondant. Ces 20 cycles des signaux de transfert ST1, ST2 représentent le temps de chargement TC du registre de lecture RL ; et à la fin de ce temps de chargement, chaque étage du registre de lecture contient la somme des charges engendrées dans toute la colonne intermédiaire CI1 à CI22 correspondante.

A la fin de ce temps de chargement TC, le registre de lecture peut évacuer toutes les informations qu'il contient (sous forme de charges), vers un circuit de sortie (auquel il est relié). L'étage de sortie peut comporter par exemple, de façon traditionnelle, un amplificateur 10 délivrant un signal de sortie en tension O.S. en fonction de chaque quantité de charges délivrée par le registre de lecture RL.

Le registre de lecture RL1 est d'un type classique fonctionnant par exemple en biphasé sous l'action de deux signaux de transfert de registre STR1, STR2 ayant des phases opposées. A la fin du temps de chargement TC, les deux signaux de commande de transfert sont appliqués au registre de lecture RL1, et successivement les charges contenues dans chaque étage de lecture EL1 à EL22 sont appliquées au circuit de sortie 10, alors que la zone image intègre l'image suivante.

En référence à nouveau à la figure 1, on peut voir sur cette dernière que pour chaque ligne principale L1 à L5, le registre de lecture RL1 à RL5 est commun pour tous les gros pixels PX1 à PX75 appartenant à une même ligne. Chaque pixel PX1 à PX75 étant constitué comme le gros pixel PX15 montré à la figure 2, le nombre des étages de lecture peut être très important.

D'autre part, les signaux de transfert ST1, ST2 appliqués aux couples d'électrodes E1, E2 (montrées sur la figure 2) sont appliqués simultanément à toutes ces électrodes E1, E2 de tous les gros pixels PX1 à PX75 d'une même ligne principale L1 à L4, à l'aide de moyens de commande (non représenté ) communs.

En conséquence, lorsque la dimension totale du capteur d'image est importante, il apparaît une limitation du fonctionnement, liée aux constantes de temps réparties des lignes de silicium polycristallin qui forment de façon classique les électrodes de photomos.

Cette limitation dans l'utilisation du capteur d'image peut être très sérieuse, si le débit d'information attendu en sortie du circuit de sortie 10 est élevé. En effet, on dispose d'une durée TL comme période de ligne, durant laquelle doivent être accomplies successivement d'une part, l'opération de chargement dans le registre de lecture RL1 à RL5 pendant le temps TC, puis ensuite la lecture par l'étage de sortie 10 de toutes les informations contenues dans le registre de lecture RL1 à RL5 pendant un temps tl : si on augmente le temps de chargement TC du fait des constantes réparties, on réduit d'autant le temps de lecture tl des M gros pixels constitués chacun de i colonnes intermédiaires.

Ceci peut conduire à augmenter la fréquence de commande des registres de lecture RL1 à RL5 jusqu'à des valeurs où le fonctionnement peut être très difficile à assurer.

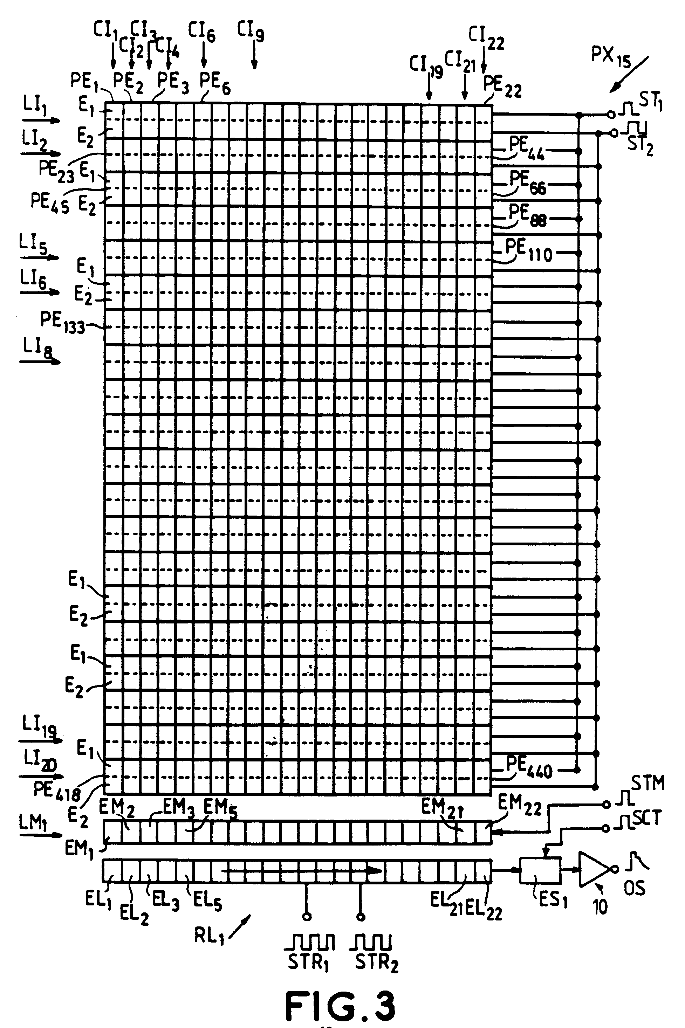

En vue de minimiser la fréquence de commande de registre de lecture RL1 à RL5, et suivant une nouvelle caractéristique de l'invention, un étage de sommations peut être interposé entre le registre de lecture RL1 à RL5 et chacune des colonnes intermédiaires de tous les gros pixels qui constituent une ligne principale L1 à L5. Cette version de l'invention à étages de sommation est symbolisée sur la figure 1 à l'aide d'une ligne LM1 à LM5 symbolisées en traits pointillés, et elle est explicitée plus en détail en référence à la figure 3. Il est à noter en outre que l'on a représenté sur la figure 1, également en traits pointillés, un étage sommateur de sortie ES1 à ES5, interposé entre chaque registre de lecture RL1 à RL5 et chaque circuit de sortie 10, et dont le fonctionnement est expliqué également en référence à la figure 3.

La figure 3 montre le quinzième pixel PX15 par une vue semblable à celle de la figure 2, à la différence que, d'une part, un étage de sommation EM1 à EM22 est interposé entre chaque colonne intermédiaire CI1 à CI22 et chaque étage de lecture EL1 à EL22 ; et que d'autre part un étage sommateur ES1 de sortie est disposé en série entre le registre de lecture RL1 et le circuit de sortie 10.

Chaque étage de sommation EM1 à EM22 est en lui-même classique, réalisé par exemple suivant la technologie MOS, et il peut d'ailleurs être constitué comme un pixel élémentaire PE1 à PE440.

La fonction de chacun de ces étages de sommation est d'accueillir pratiquement en permanence et de stocker, les charges engendrées par tous les pixels élémentaires de la colonne intermédiaire à laquelle ils correspondent chacun.

Dans ces conditions, il suffit d'appliquer en permanence les signaux de transfert ST1, ST2 aux couples d'électrodes E1, E2 pour que dans chaque colonne intermédiaire CI1 à CI22 on transfère en permanence, dans l'étage de sommation EM1 à EM22 correspondant, les charges créées dans la colonne intermédiaire, alors que dans l'exemple décrit en référence à la figure 2, le transfert dans les colonnes intermédiaires est limité au temps de chargement TC. A la fin de la période ligne Tl, c'est-à-dire à la fin du temps d'intégration ou temps d'exposition à la lumière, les charges accumulées dans chaque étage de sommation EM1 à EM22 sont transférées quasi instantanément dans l'étage de lecture EL1 à EL22 correspondant. En effet, il suffit pour cela d'un pas de transfert qui est réalisé sous la commande d'un signal de transfert mémoire STM appliqué simultanément à tous les étages de sommation EM1 à EM22.

Les signaux de commande de transfert SC1, SC2 sont ensuite appliqués au registre de lecture RL1, afin d'évacuer vers le circuit de sortie 10 les informations ou charges contenues dans chacun des étages de lecture EL1 à EL22.

Cette méthode conduit à réduire au point de pratiquement supprimer le temps de chargement TC, et permet ainsi d'accorder pratiquement la totalité de la durée du temps de ligne TL aux transferts dans les registres de lecture RL1 à RL5 c'est-à-dire à la lecture des informations ou charges par le circuit de sortie 10.

Ainsi, on minimise du même coup la fréquence des signaux de commande appliqués aux registres de lectures RL1 à RL5, et la fréquence des signaux de transfert ST1, ST2 appliqués aux couples d'électrodes E1, E2, c'est-à-dire à la zone image. En effet, le transfert dans les colonnes intermédiaires étant permanent, sa durée pour une colonne intermédiaire entière c'est-à-dire la durée du transfert des j lignes intermédiaires, peut être portées au maximum qui est la durée d'une période ligne TL.

Suivant une autre caractéristique de l'invention, un étage sommateur ES1 à ES5 de sortie est intercalé entre le registre de lecture RL1 et l'étage de sortie 10. Cet étage sommateur permet de sommer les quantités de charges contenues dans une succession donnée d'étage de lecture des registres de lecture RL1 à RL5, et correspondant aux i colonnes intermédiaires (i = 22 dans l'exemple) d'un gros pixel ;les charges peuvent être délivrées par l'étage sommateur ES1 sous la forme de paquets, comprenant chacun la somme des charges délivrées par toutes les colonnes intermédiaires d'un gros pixel. Par suite, pendant le temps de la période ligne TL, le débit en sortie du circuit de sortie 10 correspond à la lecture de M gros pixels, et non plus de M fois i colonnes intermédiaires. Il en résulte que la bande passante nécessaire pour l'amplificateur du circuit de sortie 10 peut être réduite, ce qui conduit à une réduction significative du bruit "RMS" (de l'anglais "Root Mean Square") de lecture en sortie du capteur d'image. L'étage sommateur ES1 de sortie 20 peut être constitué par exemple comme un étage de sommation EM1 à EM22. Il suffit de commander le transfert des charges qu'il contient, vers le circuit de sortie 10, à l'aide d'un signal de commande de transfert SCT qui lui est appliqué avec une relation de phase déterminée par rapport au transfert du registre de lecture ; un signal de commande de transfert SCT étant appliqué à l'étage sommateur ES1 en raison de i transferts dans le registre de lecture RL1. Bien entendu, l'étage sommateur ES1 doit avoir la capacité de stocker toutes les charges engendrées par un gros pixel PX1 à PX75, c'est-à-dire la somme des charges produites par j fois l pixels élémentaires.

L'étage sommateur ES1 de sortie peut être intercalé entre le registre de lecture et l'étage de sortie 10, aussi bien dans la version avec étages de sommation EM1 à EM22, que dans celle décrite en référence à la figure 2.

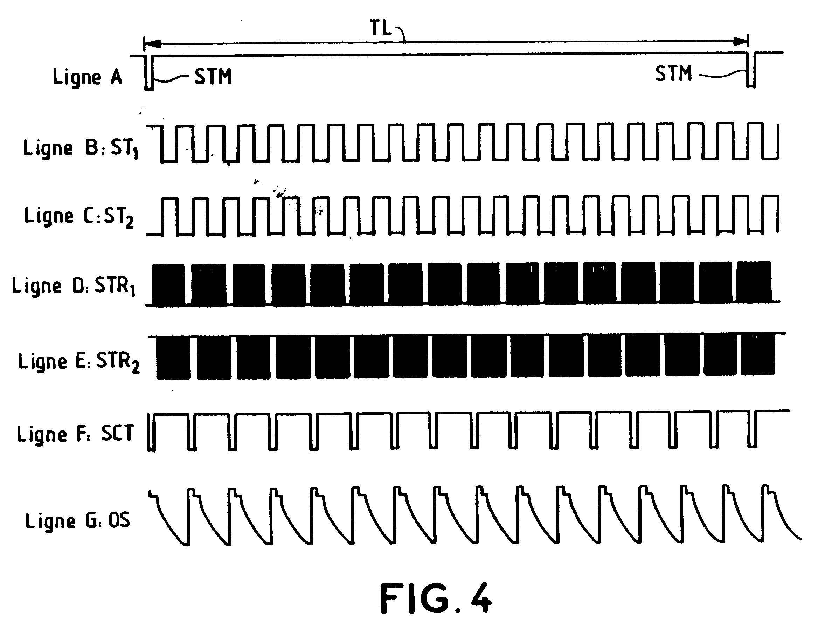

La figure 4 est un chronogramme qui par des lignes A à G illustre, à titre d'exemple non limitatif, le fonctionnement du capteur d'image dans la version avec étages de sommation EM1 à EM22 et étage sommateur de sortie ES1 à ES5.

La ligne A représente la durée d'une période ligne TL, période qui est définie entre deux signaux de transfert STM successifs appliqués aux étages de sommation EM1 à EM22.

Les lignes B et C représentent respectivement une succession de premiers et seconds signaux de transfert ST1, ST2 appliqués aux couples d'électrodes E1, E2 de chaque pixel élémentaire PE1 à PE440, avec des phases opposées. Compte-tenu de l'exemple décrit dans lequel chaque colonne intermédiaire comporte 20 pixels élémentaires, 20 signaux de transfert ST1, ST2 se succèdent dans le temps d'une période ligne TL.

Les lignes D et E représentent les deux signaux de transfert de registre STR1, STR2 appliqués aux registres de lecture RL1 à RL5. En supposant que les lignes principales L1 à L5 de gros pixels PX1 à PX75 contiennent 15 gros pixels chacune et que chaque gros pixel contienne 22 colonnes intermédiaires, il faut que durant le temps de la période ligne TL, chaque registre de lecture RL1 à RL5 réalise 15 fois 22 transferts vers l'étage sommateur de sortie ES1 à ES5 ; ceci sous la commande des signaux de transfert de registre STR1, STR2. Pour matérialiser ce fonctionnement, les signaux STR1, STR2 ont été groupés en paquets de 22 signaux chacun.

La ligne F représente une succession de signaux de commande de transfert SCT appliqués à l'étage sommateur de sortie ES1 à ES5, pendant le temps de la période ligne TL, à raison d'un signal de commande SCT pour 22 signaux de transfert de registre STR1, ou STR2, c'est-à-dire pour chaque paquet de ces signaux tels qu'ils sont représentés aux lignes D et E. Chacun de ces signaux a pour effet d'appliquer au circuit de sortie 10 une quantité de charge qui est la quantité totale produite par un gros pixel.

La ligne G illustre la succession de signaux de sortie O.S. délivrés par le circuit de sortie 10, à une même fréquence que les signaux de commande de transfert SCT appliqués à l'étage sommateur de sortie ES1 à ES5.

## Revendications

1. Dispositif capteur d'images comportant un réseau de surfaces photosensibles principales (PX1 à PX75) disposées suivant N lignes principales (L1 à L5) et M colonnes principales (CI1 à CI15) avec N supérieur ou égal à 1 et M supérieur ou égal à 1, chaque surface photosensible principale produisant des charges en fonction de son éclairement, caractérisé en ce que chaque surface photosensible principale comprend un réseau de photomos (PE1 à PE440) disposés suivant j lignes intermédiaires (LI1 à LI20) et i colonnes intermédiaires (CI1 à CI22), avec j supérieur ou égal à 2 et i supérieur ou égal 1, lesdits photomos d'une même surface photosensible principale étant éclairés simultanément, en ce que chaque ligne (L1 à L5) de surfaces photosensibles principales (PX1 à PX75) comporte un registre de lecture (RL1 à RL5) ayant au moins autant d'étages de lecture (EL1 à EL22) qu'il y a de colonnes intermédiaires dans une ligne principale, chaque succession de photomos suivant le sens des colonnes intermédiaires constituant un registre à décalage aboutissant à un étage de lecture, et en ce que chaque étage de lecture a la capacité de stocker la totalité des charges accumulées dans la colonne intermédiaire correspondante.

2. Dispositif capteur suivant la revendication 1, caractérisé en ce que le nombre N de lignes principales est supérieur ou égal à 2.

3. Dispositif capteur suivant l'une des revendications précédentes, caractérisé en ce qu'un étage de sommation (EM1 à EM22) est intercalé entre chaque colonne intermédiaire (CI1 à CI22) et l'étage de lecture (EL1 à EL22) correspondant.

4. Dispositif capteur suivant la revendication 3, caractérisé en ce que chaque étage de sommation (EM1 à EM22) a la capacité de stocker toutes les charges produites dans la colonne intermédiaire (CI1 à CI22) à laquelle il correspond.

5. Dispositif capteur suivant l'une des revendications précédentes, caractérisé en ce que dans chaque ligne principale (L1 à L5) le registre de lecture (RL1 à RL5) transfère les charges vers un circuit de sortie (10), et en ce qu'entre le registre de lecture et l'étage de sortie est intercalé un étage sommateur (ES1 à ES5).

6. Dispositif capteur suivant la revendication 5, caractérisé en ce que l'étage sommateur (ES1 à ES5) a la capacité de stocker toutes les charges produites par une surface photosensible principale (PX1 à PX75), et qu'il délivre au circuit de sortie (10) toutes les charges d'une surface photosensible principale sous la forme d'un unique paquet de charge.

## Patentansprüche

1. Bildaufnahmevorrichtung mit einer Gruppe lichtempfindlicher Hauptflächen (PX1 bis PX75), die längs N Hauptzeilen (L1 bis L5) und M Hauptspalten (CI1 bis CI15) mit N größer oder gleich 1 und M größer oder gleich 1 angeordnet sind, wobei jede lichtempfindliche Hauptfläche abhängig von ihrer Beleuchtung Ladungen erzeugt, dadurch gekennzeichnet, daß jede lichtempfindliche Hauptfläche eine Gruppe aus Photo-MOS-Elementen (PE1 bis PE440) enthält, die längs j Zwischenzeilen (LI1 bis LI20) und i Zwischenspalten (CI1 bis CI22) angeordnet sind, mit j größer oder gleich 2 und i größer oder gleich 1, wobei die Photo-MOS-Elemente der gleichen lichtempfindlichen Hauptfläche gleichzeitig beleuchtet werden, daß jede Zeile (L1 bis L5) der lichtempfindlichen Hauptflächen (PX1 bis PX75) ein Leseregister (RL1 bis RL5) enthält, das wenigstens ebensoviele Lesestufen (EL1 bis EL22) enthält, wie Zwischenspalten in einer Hauptzeile vorhanden sind, wobei jede Aufeinanderfolge der Photo-MOS-Elemente in Richtung der Zwischenspalten ein Schieberegister bildet, das an eine Lesestufe angrenzt, und daß jede Lesestufe die Kapazität hat, die Gesamtheit der in der entsprechenden Zwischenspalte angesammelten Ladungen zu speichern.

2. Aufnahmevorrichtung nach Anspruch 1, dadurch gekennzeichnet, daß die Anzahl N der Hauptzeilen größer oder gleich 2 ist.

3. Aufnahmevorrichtung nach einem der vorhergehenden Ansprüche, dadurch gekennzeichnet, daß zwischen jede Zwischenspalte (CI1 bis CI22) und die entsprechende Lesestufe (EL1 bis EL22) eine Summierstufe (EM1 bis EM22) eingefügt ist.

4. Aufnahmevorrichtung nach Anspruch 3, dadurch gekennzeichnet, daß jede Summierstufe (EM1 bis EM22) die Kapazität hat, alle Ladungen zu speichern, die in der Zwischenspalte (CI1 bis CI22) erzeugt werden, die ihr entspricht.

5. Aufnahmevorrichtung nach einem der vorhergehenden Ansprüche, dadurch gekennzeichnet, daß in jeder Hauptzeile (L1 bis L5) das Leseregister (RL1 bis RL5) die Ladungen zu einer Ausgangsschaltung (10) überträgt, und daß zwischen dem Leseregister und der Ausgangsstufe eine Summierstufe (ES1 bis ES5) eingefügt ist.

6. Aufnahmevorrichtung nach Anspruch 5, dadurch gekennzeichnet, daß die Summierstufe (ES1 bis ES5) die Kapazität hat, alle Ladungen zu speichern, die durch eine lichtempfindliche Hauptfläche (PX1 bis PX75) erzeugt werden, und daß sie an die Ausgangsschaltung (10) alle Ladungen einer lichtempfindlichen Hauptfläche in Form eines einzigen Ladungspakets liefert.

## Claims

1. Image sensor device comprising a network of main photosensitive surfaces (PX1 to PX75) placed along N main lines (L1 to L5) and M main columns (CI1 to CI15) with N greater than or equal to 1 and M greater than or equal to 1, each main photosensitive surface producing charges as a function of its illumination, characterized in that each main photosensitive surface comprises a photomos network (PE1 to PE440) placed along j intermediate lines (LI1 to LI20) and i intermediate columns (CI1 to CI22) with j greater than or equal to 2 and i greater than or equal to 1, the said photomos of one and the same main photosensitive surface being illuminated simultaneously, in that each line (L1 to L5) of main photosensitive surfaces (PX1 to PX75) comprises a reading register (RL1 to RL5) having at least as many reading stages (EL1 to EL22) as there are intermediate columns in a main line, each photomos sequence following the direction of the intermediate columns constituting a shift register ending in a reading stage, and in that each reading stage has the capacity to store all the charges accumulated in the corresponding intermediate column.

2. Sensor device according to Claim 1, characterized in that the number N of main lines is greater than or equal to 2.

3. Sensor device according to one of the preceding claims, characterized in that a summation stage (EM1 to EM22) is interposed between each intermediate column (CI1 to CI22) and the corresponding reading stage (EL1 to EL22).

4. Sensor device according to Claim 3, characterized in that each summation stage (EM1 to EM22) has the capacity to store all the charges produced in the intermediate column (CI1 to CI22) to which it corresponds.

5. Sensor device according to one of the preceding claims characterized in that in each main line (L1 to L5), the reading register (RL1 to RL5) transfers the charges to an output circuit (10) and in that a summing stage (ES1 to ES5) is interposed between the reading register and the output stage.

6. Sensor device according to Claim 5, characterized in that the summing stage (ES1 to ES5) has the capacity to store all the charges produced by a main photosensitive surface (PX1 to PX75) and that it delivers to the output circuit (10) all the charges of a main photosensitive surface in the form of a single charge packet.
